# EUROPEAN PATENT SPECIFICATION

(11) **EP 0 325 181 B1**
(45) Date of publication and mention of the grant of the patent: **05.04.1995**
(21) Application number: 89100610.8
(22) Date of filing: 14.01.1989
(51) Int. Cl.: H01L 21/82, H01L 21/31, H01L 27/06, H01L 21/306

(54) **A method of manufacturing a polysilicon emitter and a polysilicon gate using the same etch of polysilicon on a thin gate oxide**
Verfahren zum Herstellen eines Polysiliciumemitters und eines Polysiliciumgates durch gleichzeitiges Ätzen von Polysilicium auf einem dünnen Gateoxid
Procédé pour fabriquer un émetteur en polysilicium et une grille en polysilicium utilisant la même gravure de polysilicium sur un oxyde à grille mince

(30) Priority: 19.01.1988 US 145076
(43) Date of publication of application: 26.07.1989
(73) Proprietor: NATIONAL SEMICONDUCTOR CORPORATION, Santa Clara California 95051-8090 (US)
(72) Inventor: Brassington, Michael P., Sunnyvale, CA 94087 (US); Razouk, Reda R., Sunnyvale, CA 94087 (US); El-Diwany, Monir H., Santa Clara, CA 95051 (US); Tuntasood, Prateep, San Jose, CA 95148 (US)
(74) Representative: Sparing Röhl Henseler Patentanwälte

(56) References cited:
- EP-A- 0 196 757
- EP-A- 0 219 831
- EP-A- 0 232 497
- EP-A- 0 239 652

## Description

### BACKGROUND OF THE INVENTION

### 1. Field Of The Invention

This invention relates to semiconductor devices and, more particularly, to the simultaneous formation of bipolar and metal oxide semiconductor (MOS) devices on the same silicon substrate.

### 2. Description Of The Relevant Art

Methods for the fabrication of bipolar devices and MOS devices are known. Typically, bipolar devices are fabricated separately from MOS devices because of the structural differences between the two types of devices. This means that a circuit which uses both bipolar and MOS devices must be constructed using discrete chips, which increases the size and cost of the product. EP-A-0 196 757 discloses a method defined by the preamble of claim 1.

If bipolar and MOS devices are to be combined, an integrated approach to device fabrication must be devised. However, applying the fabrication techniques used for one type of device to another type of device typically degrades the performance of the other device. For example, a common method for making electrical contact to a silicon substrate in a bipolar transistor involves the use of a layer of polysilicon deposited on the surface of the substrate. Electrical contact to the silicon substrate is made through this layer of polysilicon. The resulting structure is termed a "buried contact." However, the polysilicon/silicon interface layer increases the series resistance through the device. This is insignificant in bipolar devices, because the base of bipolar devices has small current flowing through it, and bipolar devices have intrinsically high resistances. However, the source and drain in MOS devices carry all of the current, so any increase in series resistance significantly affects performance of the devices. Series resistance can be improved by increasing the contact area, but with a resulting decrease in yield. Finally, the thin gate oxide layer used in MOS devices is subject to contamination and mechanical damage when subjected to bipolar fabrication methods.

### SUMMARY OF THE INVENTION

The present invention is directed to a method of making bipolar and MOS devices simultaneously using a single fabrication process. The process according to Claim 1 of the present invention employs the use of buried contacts without significantly affecting the performance of the MOS devices, and a very thin gate oxide layer may be used in the MOS devices without jeopardizing the integrity or performance of the devices.

In one embodiment of the present invention, a silicon substrate is divided into bipolar and MOS regions. A thin layer of gate oxide then is thermally grown on the silicon substrate. A thin layer of polysilicon is deposited on the gate oxide layer to protect the gate oxide layer during subsequent processing, and then both the thin polysilicon layer and the gate oxide layer are removed from the bipolar region where the emitter is to be formed. To maintain the integrity of the gate oxide layer, the photoresist mask used during the polysilicon etch is retained during the gate oxide etch, and the gate oxide is etched in a buffered oxide etch solution. A thick layer of polysilicon then is deposited on the bipolar and MOS regions of the silicon substrate, and the substrate is masked for forming the emitter and gates of the bipolar and MOS devices, respectively, After the emitter and gate locations are masked, the polysilicon is simultaneously etched from the bipolar and MOS regions for forming the respective emitter and gates. Since the polysilicon over the area where the emitter is formed is thinner than the polysilicon over the MOS region, the silicon substrate surrounding the emitter is etched for forming the emitter island. The areas for the base and collector of the bipolar device and the source and drain of the MOS devices are selectively masked during etching of the polysilicon for providing buried contacts to these regions, if desired.

These and other features and advantages of the invention will become apparent to those skilled in the art upon a reading of the following detailed description of the invention, which should be taken in conjunction with the accompanying drawings.

### BRIEF DESCRIPTION OF THE DRAWINGS

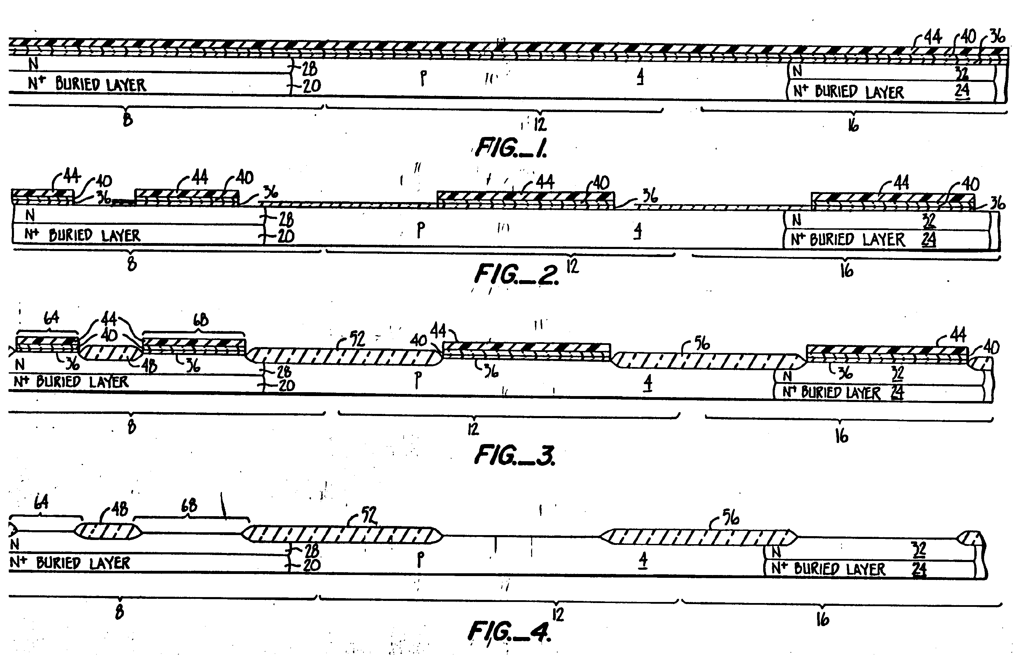

Figs. 1-16 illustrate the steps of forming a combination bipolar/CMOS device according to the present invention.

### DETAILED DESCRIPTION OF THE PREFERRED EMBODIMENTS

Fig. 1 shows a silicon substrate 4 after having undergone preliminary processing according to conventional methods. For example, silicon substrate 4 has been processed to form a bipolar region 8, an NMOS region 12, and a PMOS region 16. Bipolar region 8 is intended to be used for forming an NPN transistor, whereas NMOS region 12 is intended to be used for forming an N-channel MOS device, and PMOS region 16 is intended to be used for forming a P-channel MOS device.

Silicon substrate 4 is formed of a P-type material. Consequently, bipolar region 8 and PMOS region 16 have formed therein arsenic doped N+ buried layers 20 and 24, respectively. N+ buried layers 20 and 24 may be formed, for example, by the process disclosed in U.S. -A- 3,648,125 to Douglas L. Peltzer, and assigned to Fairchild Camera and Instrument Corp. Formed above N+ buried layers 20 and 24 are N-wells 28 and 32, respectively, formed by diffusion of an appropriate N-type impurity, such as phosphorous, into substrate 4 according to well known techniques. N+ buried layers 20 and 24 typically have an impurity concentration of approximately 1 x 10²⁰ atoms/cm³ and are approximately 1 »m thick, whereas N-wells 28 and 32 typically have an impurity concentration of approximately 1 x 10¹⁶ atoms/cm³ and a thickness of approximately 0.8 »m.

Disposed above substrate 4 are a layer of silicon dioxide 36 and a layer of silicon nitride 40. Silicon dioxide layer 36 preferably is thermally grown on the surface of substrate 4 by placing substrate 4 in an oxygen or steam, preferably steam, environment at a temperature of approximately 900°C for 30 minutes. Silicon dioxide layer 36 has a thickness in the range of from approximately 350 angstroms to 450 angstroms, preferably 400 angstroms (10 Å = 1 nm = 10⁻³ »m). Silicon nitride layer 40 may be deposited on top of silicon dioxide layer 36 by chemical vapor deposition (CVD). Silicon nitride layer 40 has a thickness in the range of from approximately 1500 angstroms to approximately 1700 angstroms, preferably 1600 angstroms.

Finally, a layer of photoresist 44 is deposited on silicon nitride layer 40 through a blanket coating, preferably by spinning, to a thickness of approximately 1.5»m. The photoresist layer 44 is subjected to a pattern exposure so that development of the photoresist produces portions of photoresist layer 44, as shown in Fig. 2. These remaining portions of photoresist layer 44 function as a mask to enable etching of the layer 40 of silicon nitride in the areas not protected by the remaining portions of photoresist layer 44. This etching preferably is a dry etch with a plasma, such as SF₆. This produces the structure illustrated in Fig. 2.

After silicon nitride layer 40 is etched, semi-recessed isolation oxide (SROX) regions 48, 52, and 56 are formed by thermal oxidation in the presence of dry oxygen or steam. Preferably, the SROX regions 48, 52, and 56 are formed by thermal oxidation in steam at a temperature of 900°C to a thickness of from approximately 5000 angstroms to approximately 6000 angstroms, preferably 5500 angstroms. As a result, bipolar region 8 is electrically isolated from NMOS region 12 by SROX region 52, and NMOS region 12 is electrically isolated from PMOS region 16 by SROX region 56. SROX region 48 separates bipolar region 8 into a collector region 64 and a base/emitter region 68. The remaining portions of photoresist layer 44 are removed by a solvent or oxygen plasma, for example.

After formation of the SROX regions 48, 52, and 56, the remaining portions of silicon nitride layer 40 and silicon dioxide layer 36 are removed to produce the structure shown in Fig. 4. The portions of silicon nitride layer 40 may be removed by wet etching in orthophosphoric acid, and silicon dioxide layer 36 may be removed by wet etching in hydroflouric acid.

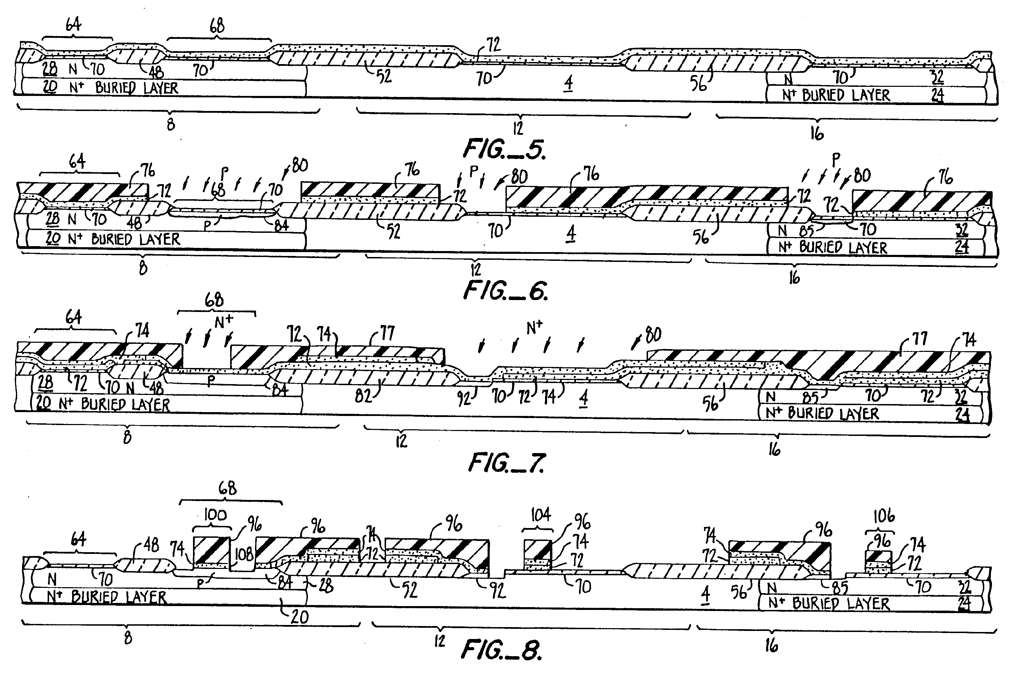

As shown in Fig. 5, the next step is to form a thin layer of silicon dioxide 70 on the exposed surfaces of substrate 4. Silicon dioxide layer 70 preferably is grown in the same manner as silicon dioxide layer 36, and it has a thickness in the range of from approximately 150 angstroms to 300 angstroms, preferably 170 angstroms. This range has been found by experimentation to be critical in order to avoid contamination and mechanical damage during subsequent processing. Next, a thin polycrystalline silicon layer 72 is deposited as a blanket coating over the silicon dioxide layer 70 and the SROX regions 48, 52, and 56. The polycrystalline silicon layer 72 is deposited by CVD, and it has a thickness of from approximately 500 angstroms to 1000 angstroms, preferably 700 angstroms. This thickness of polycrystalline silicon layer 72 has been found by experimentation to be critical to protect silicon dioxide layer 70 during subsequent processing.

Next, as shown in Fig. 6, a photoresist layer 76 is deposited as a blanket coating over polycrystalline silicon layer 72 in the same manner as photoresist layer 44. After photoresist layer 76 is deposited and developed, openings 80 are formed over base/emitter region 68 and over those regions where buried contacts to the silicon substrate are desired. Two such regions are shown. With the remaining portions of photoresist layer 76 functioning as a mask, the exposed sections of polycrystalline silicon layer 72 are removed by a dry etch. The dry etch may be performed with a plasma, such as SF₆. Then, the exposed portions of gate oxide layer 70 are ion-implanted with a P-type impurity, preferably boron, with an energy of 40 KeV to a concentration of approximately 1 x 10¹⁸ atoms/cm³. This P-type implant forms the initial base region 84 in N-well 28 of bipolar region 8 and the source contact region 85 in PMOS region 16. On the other hand, the P-type implant has a negligible effect on the P-type substrate beneath the exposed region in NMOS region 12.

Next, as shown in Fig. 7, the exposed portions of gate oxide layer 70 are removed through a buffered oxide etch while maintaining photoresist layer 76 as a mask. Photoresist layer 76 then is removed, and a relatively thick polycrystalline silicon layer 74 is deposited as a blanket coating by CVD over the remaining portions of polycrystalline silicon layer 72 and the exposed areas of silicon substrate 4. Polycrystalline silicon layer 74 is substantially thicker than polycrystalline silicon layer 72, and preferably has a thickness of from approximately 2200 angstroms to 2800 angstroms, preferably 2500 angstroms. Next, a layer of photoresist 77 is deposited and developed to form openings 88 over base/emitter region 68, where an emitter is to be formed, and over NMOS region 12. Polycrystalline silicon layers 72 and 74 then are doped by ion implantation to reduce their resistivity. Preferably, an N-type impurity, such as arsenic, is used, and the ions are implanted with an energy of 80 KeV to a concentration of from approximately 1 x 10¹⁵ to 1 x 10¹⁶ atoms/cm³. This is to make the conductivity of the exposed polysilicon layers as high as possible to function as a conductor. The remaining portions of photoresist layer 77 are removed, and the structure is then annealed at a temperature of from approximately 900°C to 950°C for approximately 30 minutes in a nitrogen atmosphere. This causes diffusion to expand the initial base region 84 and P+ region 85 and to form N+ region 92.

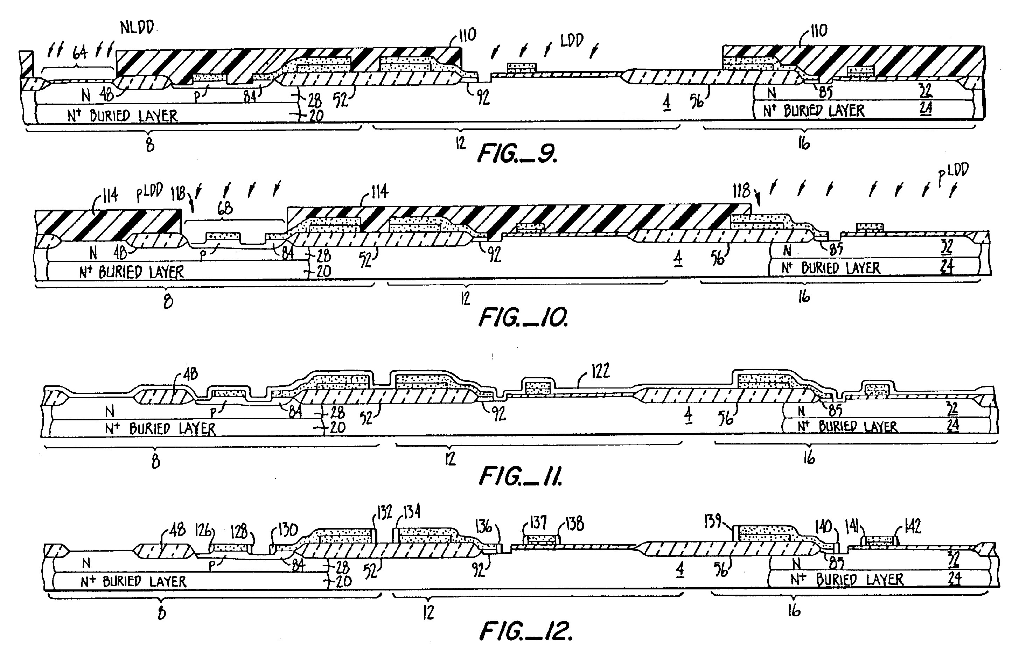

Next, a shown in Fig. 8, a photoresist layer 96 is deposited over polysilicon layer 74. Photoresist layer 96 is developed to expose all areas of polysilicon layer 74, except over a region 100 which will form the emitter of the bipolar device, over a region 104 which will form the gate of the NMOS device, over a region 106 which will form the gate of the PMOS device, and over the regions of polysilicon layer 74 where buried contacts to the silicon substrate are to be made, e.g., over SROX region 52. The exposed portions of polysilicon layer 74 then are etched by a plasma, such as SF₆, until the exposed portions of polysilicon are removed. Since some areas of polysilicon comprise polysilicon layers 72 and 74, whereas other areas of polysilicon comprise only polysilicon layer 74, portions of substrate 4 not protected by gate oxide layer 70 are etched to a depth approximately equal to that of the polysilicon layer 72. This occurs in base/emitter region 68 and forms an emitter island 108. Consequently, the thickness of polysilicon layers 72 and 74 in regions 104 and 106, which form the NMOS and PMOS gates, is the same as the depth of polysilicon layer 74 and emitter island 108 in region 100.

Next, as shown in Fig. 9, photoresist layer 96 is removed and a photoresist layer 110 is deposited over substrate 4 everywhere except collector region 64 of bipolar region 8 and NMOS region 12. Then, a lightly doped drain (LDD) implant is performed with phosphorous ions on the exposed regions at an implantation energy of 40 KeV to a concentration of from approximately 1 x 10¹³ to 1 x 10¹⁴ atoms/cm³.

Next, as shown in Fig. 10, photoresist layer 110 is removed and a photoresist layer 114 is deposited over substrate 4. Photoresist layer 114 then is developed to form openings 118 over base/emitter region 68 and PMOS region 16. Then, a P-type LDD implant is performed, preferably with boron difluoride at an implantation energy of 50 KeV to a concentration of from approximately 1 x 10¹³ to 1 x 10¹⁴, preferably 5 x 10¹³ atoms/cm³. Thereafter, photoresist layer 114 is removed.

Next, as shown in Fig. 11, a conformal silicon dioxide layer is deposited by CVD over the entire surface of substrate 4 to a thickness of from approximately 1500 to 4000 angstroms, preferably 2000 angstroms. Silicon dioxide layer 122 then is subjected to an LTO densification by heating at approximately 900°C for approximately 15 minutes.

Then, as shown in Fig. 12, silicon dioxide layer 122 is subjected to an anisotropic etch, preferably in a plasma comprising He·C₂F₆·CHF₃ to form spacers 126, 128, 130, 132, 134, 136, 137, 138, 139, 140, 141, and 142.

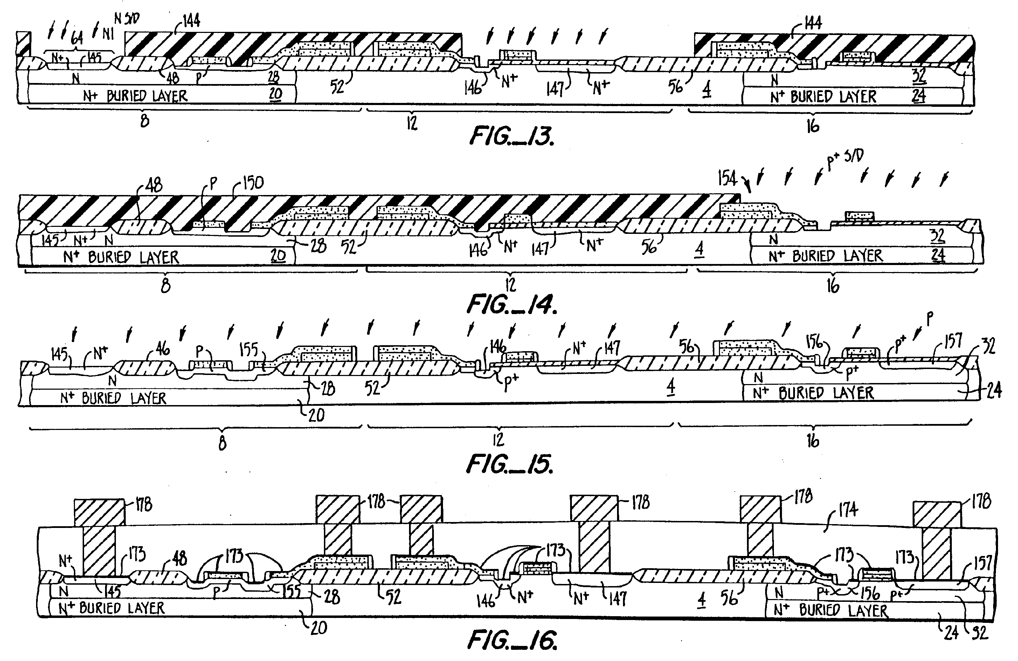

In the next step, shown in Fig. 13, a photoresist mask 144, similar to photoresist mask 110, is deposited and developed to expose collector region 64 and NMOS region 12. An N-type ion implant then is performed, preferably with arsenic, at an implantation energy of 100 KeV to a concentration of approximately 5 x 10¹⁵ atoms/cm³ for forming the source and drain regions of the NMOS device and the collector of the bipolar device. Afterwards, substrate 4 is annealed at a temperature of 900°C for approximately 30 minutes to form N+ collector 145, in bipolar region 8, and N+ source 146 (which merges with N+ region 92) and N+ drain 147 in NMOS region 12.

Similarly, as shown in Fig. 14, a photoresist layer 150 is deposited and developed to form an opening 154 over PMOS region 16, and then a P-type ion implant is performed with boron difluoride at an implantation energy of 50 KeV to a concentration of approximately 3 x 10¹⁵ atoms/cm³ for creating the source and drain of the PMOS device. Then, as shown in Fig. 15, photoresist layer 150 is removed and a final blanket, unmasked P-type implant with BF₂ at an implantation energy of 50 KeV to a concentration of 1 x 10¹⁴ atoms/cm³ is performed for forming the extrinsic base of the bipolar device. Substrate 4 then is annealed at a temperature of 900° for approximately 40 minutes to form base 155 (which merges with region 84), in bipolar region 8, and P+ source 156 (which merges with P+ region 85) and P+ drain 157 in PMOS region 16.

Finally, as shown in Fig. 16, the exposed silicon and polysilicon regions are silicided using well known techniques to form silicide layers 173. The substrate 4 is covered with a planarizing layer 174 of deposited oxide using well known techniques, such as LTO. Planarizing layer 174 then is etched, and metal contacts 178 are made to the conductive regions also using well known techniques.

While the above is a complete description of a preferred embodiment of the present invention, various modifications may be employed. For example, techniques may be used to construct a single MOS device without the bipolar devices, and the base, collector, and emitter of bipolar devices formed and the source, drain, and gate of MOS devices formed may be selectively electrically contacted with buried contacts, as desired.

## Claims

1. A method of making a polysilicon emitter and a polysilicon gate in a semiconductor device, comprising the steps of:
growing a thin layer (70) of gate oxide on emitter and gate regions of a silicon substrate (4),
removing the gate oxide layer from the emitter region of the silicon substrate,
depositing a thick polysilicon layer (74) on the emitter and gate regions of the silicon substrate,
masking the emitter and gate regions for defining a respective emitter and gate,
simultaneously etching portions of the polysilicon from the emitter and gate regions for forming the respective emitter and gate, **characterized in that** prior to the gate oxide removing step, a thin layer (72) of polysilicon is deposited on the gate oxide layer and is subsequently removed from the emitter region, and that upon said simultaneous etching step the etch in the emitter region extends into the substrate by an amount corresponding to the thickness of said thin polysilicon layer.

2. The method according to claim 1 wherein the polysilicon layer removing step comprises the steps of:
depositing a photoresist layer (76) as a blanket coating above the thin polysilicon layer;
developing the photoresist layer for forming an opening (80) in the photoresist layer for exposing the portion of the polysilicon layer above the emitter region; and
etching the exposed portion of the polysilicon layer for exposing the portion of the gate oxide layer above the emitter region.

3. The method according to claim 2 wherein the gate oxide layer removing step comprises the steps of:
retaining the photoresist layer (76); and
etching the exposed portion of the gate oxide layer (70) in a buffered oxide etching solution.

4. The method according to claim 3 wherein the gate oxide growing step comprises the step of:
growing a layer (70) of silicon dioxide on emitter and gate regions of the silicon substrate, the silicon dioxide having a thickness in the range of from approximately 15 nm (150 angstroms) to approximately 30 nm (300 angstroms).

5. The method according to claim 4 wherein the thin polysilicon layer depositing step comprises the step of depositing a polysilicon layer (72) to a thickness of from approximately 50 nm (500 angstroms) to approximately 100 nm (1000 angstroms).

6. The method according to claim 5 further comprising the steps of:
depositing a conformal oxide layer (122) as a blanket coating over the silicon substrate (4); and
anisotropically etching the conformal layer from the bipolar region and from the MOS region.

7. The method according to one of claims 1 to 6, comprising the steps:
forming a bipolar region (8) in said silicon substrate for a bipolar device, the bipolar region having a first region (64), termed a collector region, and a second region (68), the first and second regions being separated by a first fields oxide region (48);
forming a MOS region (12, 16) in the silicon substrate for a MOS device, the MOS region being separate from the bipolar region by a second field oxide region (52);
forming said thin gate oxide layer (70) on the bipolar region and on the MOS region;
forming said thin polysilicon layer on the bipolar region and on the MOS region;
removing the thin polysilicon layer from the second region;
removing the thin gate oxide layer from the second region;
depositing said thick polysilicon layer on the bipolar region and on the MOS region;
masking a portion of the second region for forming an emitter;
masking a portion of the MOS region for forming a gate;
simultaneously etching the polysilicon from the bipolar region and from the MOS region other than from the masked portions of the bipolar region and the MOS region;
removing the thin gate oxide layer from the collector region;
doping the collector region and the MOS region to a first conductivity type;
doping the second region to a conductivity type opposite the conductivity type of the collector region;
depositing a conformal oxide layer (122) on the bipolar region and on the MOS region; and
anisotropically etching the conformal layer from the bipolar region and from the MOS region.

## Patentansprüche

1. Ein Verfahren zum Herstellen eines Polysilicium-Emitters und eines Polysilicium-Gates in einer Halbleiterkomponente, umfassend die Schritte:
Aufwachsenlassen einer dünnen Schicht (70) aus Gate-Oxid auf Emitter- und Gate-Bereichen eines Silicium-Substrats (4),
Abtragen der Gate-Oxidschicht von dem Emitterbereich des Siliciumsubstrats,
Aufbringen einer dicken Polysiliciumschicht (74) auf den Emitter- und Gate-Bereichen des Siliciumsubstrats,
Maskieren des Emitter- und Gate-Bereichs zum Definieren eines entsprechenden Emitters und Gates,
gleichzeitiges Atzen von Abschnitten des Polysiliciums von dem Emitter- und Gate-Bereich für die Bildung des entsprechenden Emitters bzw. Gates,
dadurch gekennzeichnet, daß vor dem Schritt des Abtrags des Gate-Oxids eine dünne Schicht (72) aus Polysilicium auf der Gate-Oxid-Schicht aufgebracht wird und nachfolgend von dem Emitterbereich abgetragen wird und daß bei dem gleichzeitigen Ätzschritt die Ätzung in dem Emitterbereich sich in das Substrat um ein Maß hineinerstreckt entsprechend der Dicke der dünnen Polysiliciumschicht.

2. Das Verfahren nach Anspruch 1, bei dem der Schritt des Abtrags der Polysiliciumschicht die Schritte umfaßt:
Aufbringen einer Photoresistschicht (76) als eine Deckbeschichtung über der dünnen Polysiliciumschicht;
Entwickeln der Photoresistschicht für die Ausbildung einer Öffnung (80) in der Photoresistschicht für das Exponieren des Abschnitts der Polysiliciumschicht über dem Emitterbereich; und
Ätzen des exponierten Abschnitts der Polysiliciumschicht für das Exponieren des Abschnitts der Gate-Oxid-Schicht oberhalb des Emitterbereichs.

3. Das Verfahren nach Anspruch 2, bei dem der Schritt des Abtrags der Gate-Oxid-Schicht die Schritte umfaßt:
Beibehalten der Photoresistschicht (76) und
Ätzen des exponierten Abschnitts der Gate-Oxid-Schicht (70) in einer gepufferten Oxidätzlösung.

4. Das Verfahren nach Anspruch 3, bei dem der Schritt des Auf-wachsenlassen des Gate-Oxids den Schritt umfaßt:
Aufwachsenlassen einer Schicht (70) aus Siliciumdioxid auf Emitter- und Gatebereichen des Siliciumsubstrats, welches Silicimdioxid eine Dicke im Bereich von etwa 15 nm (150 Å) bis etwa 30 nm (300 Å) aufweist.

5. Das Verfahren nach Anspruch 4, bei dem der Schritt des Aufbringens der dünnen Polysiliciumschicht den Schritt des Aufbringens einer Polysiliciumschicht (72) bis zu einer Dicke von etwa 50 nm (500 Å) bis etwa 100 nm (1000 Å) umfaßt.

6. Das Verfahren nach Anspruch 5, ferner umfassend die Schritte:
Aufbringen einer formangepaßten Oxidschicht (122) als Deckbeschichtung über dem Siliciumsubstrat (4) und
anisotropes Ätzen der formangepaßten Schicht aus dem Bipolarbereich und aus dem MOS-Bereich.

7. Das Verfahren nach einem der Ansprüche 1 bis 6, umfassend die Schritte:
Bilden eines Bipolarbereichs (8) in dem Siliciumsubstrat für eine Bipolarkomponente, welcher Bipolarbereich einen ersten Bereich (64), als Kollektorbereich bezeichnet, und einen zweiten Bereich (68) umfaßt, welcher erste und zweite Bereich voneinander durch einen ersten Feldoxidbereich (48) getrennt sind;
Bilden eines MOS-Bereiches (12, 16) in dem Siliciumsubstrat für eine MOS-Komponente, wobei der MOS-Bereich von dem Bipolarbereich durch einen zweiten Feldoxidbereich (52) getrennt ist;
Bilden der dünnen Gate-Oxid-Schicht (70) auf dem Bipolarbereich und auf dem MOS-Bereich;
Bilden der dünnen Polysiliciumschicht auf dem Bipolarbereich und auf dem MOS-Bereich;
Abtragen der dünnen Polysiliciumschicht von dem zweiten Bereich;
Abtragen der dünnen Gate-Oxid-Schicht von dem zweiten Bereich;
Aufbringen der dicken Polysiliciumschicht auf dem Bipolarbereich und auf dem MOS-Bereich;
Maskieren eines Abschnitts des zweiten Bereichs für die Bildung eines Emitters;
Maskieren eines Abschnitts des MOS-Bereichs für die Bildung eines Gates;
gleichzeitiges Ätzen des Polysiliciums von dem Bipolarbereich und von dem MOS-Bereich mit Ausnahme der maskierten Abschnitte des Bipolarbereichs und des MOS-Bereichs;
Abtragen der dünnen Gate-Oxid-Schicht von dem Kollektorbereich;
Dotieren des Kollektorbereichs und des MOS-Bereichs auf einen ersten Leitfähigkeitstyp;
Dotieren des zweiten Bereichs auf einen Leitfähigkeitstyp entgegengesetzt dem Leitfähigkeitstyp des Kollektorbereichs;
Deponieren einer formangepaßten Oxidschicht (122) auf dem Bipolarbereich und auf dem MOS-Bereich; und
anisotropes Ätzen der formangepaßten Schicht von dem Bipolarbereich und von dem MOS-Bereich.

## Revendications

1. Procédé de réalisation d'un émetteur en polysilicium et d'une grille en polysilicium dans un dispositif semi-conducteur comprenant les étapes consistant à :
- former par croissance une fine couche (70) d'oxyde de grille sur des régions d'émetteur et de grille d'un substrat en silicium (4),
- éliminer la couche d'oxyde de grille de la région d'émetteur du substrat en silicium,
- déposer une couche de polysilicium épaisse (74) sur les régions d'émetteur et de grille du substrat en polysilicium,
- masquer les régions d'émetteur et de grille pour définir un émetteur et une grille respectives,
- graver simultanément des parties de polysilicium des régions d'émetteur et de grille pour former l'émetteur et la grille respectives, caractérisé en ce que avant l'étape d'élimination de l'oxyde de grille, on dépose une mince couche (72) de polysilicium sur la couche d'oxyde de grille qui est ultérieurement éliminée de la région d'émetteur et en ce que lors de l'étape de gravage simultané, le gravage dans la région d'émetteur s'étend dans le substrat sur une quantité correspondant à l'épaisseur de la couche de polysilicium mince.

2. Procédé selon la revendication 1 selon lequel l'étape d'élimination de la couche de polysilicium comprend les étapes consistant à :
- déposer une couche de résine photosensible (76) comme un revêtement en couverture au-dessus de la couche de polysilicium mince,
- développer la couche de résine photosensible pour former une ouverture (80) dans la couche de résine photosensible pour exposer la partie de la couche de polysilicium au-dessous de la région d'émetteur, et
- graver la partie exposée de la couche de polysilicium pour exposer la partie de la couche d'oxyde de grille au-dessus de la région d'émetteur.

3. Procédé selon la revendication 2 selon lequel l'étape d'élimination de la couche d'oxyde de grille comprend les étapes consistant à :
- conserver la couche de résine photosensible (76), et
- graver la partie exposée de la couche d'oxyde de grille (70) dans une solution de gravage d'oxyde tamponnée.

4. Procédé selon la revendication 3 selon lequel l'étape de croissance de l'oxyde de grille comprend les étapes consistant à :
- former par croissance une couche de dioxyde de silicium (70) sur les régions d'émetteur et de grille du substrat en silicium, le dioxyde de silicium ayant une épaisseur comprise dans la gamme d'approximativement 15 nm (150 angströms) à approximativement 30 nm (300 angströms).

5. Procédé selon la revendication 4 selon lequel l'étape de dépôt de la couche de polysilicium mince comprend l'étape consistant à déposer une couche de polysilicium (72) jusqu'à obtenir une épaisseur comprise entre approximativement 50 nm (500 angströms) à approximativement 100 nm (1'000 angströms).

6. Procédé selon la revendication 5 comprenant en outre les étapes consistant à :
- déposer une couche d'oxyde conforme (122) comme revêtement de couverture sur le substrat en silicium (4), et
- graver de façon anisotrope la couche conforme de la région bipolaire et de la région MOS.

7. Procédé selon l'une des revendications 1 à 6, comprenant les étapes consistant à :
- former une région bipolaire (8) dans ledit substrat en silicium pour un dispositif bipolaire, la région bipolaire ayant une première région (64) désignée région de collecteur et une deuxième région (68), la première et la deuxième région étant séparées par une première région d'oxyde de champ (48),
- former une région MOS (12, 16) dans le substrat en silicium pour un dispositif MOS, la région MOS étant séparée de la région bipolaire par une deuxième région d'oxyde de champ (52),
- former ladite couche d'oxyde de grille (70) sur la région bipolaire et sur la région MOS,
- former ladite couche de polysilicium mince sur la région bipolaire et sur la région MOS,
- éliminer la couche de polysilicium mince de la deuxième région,
- éliminer la couche d'oxyde de grille de la deuxième région,
- déposer ladite couche de polysilicium épaisse sur la région bipolaire et sur la région MOS,
- masquer une partie de la deuxième région pour former un émetteur,
- masquer une partie de la région MOS pour former une grille,
- graver simultanément le polysilicium de la région bipolaire et de la région MOS autre que la partie masquée de la région bipolaire et de la région MOS,
- éliminer la couche d'oxyde de grille mince de la région de collecteur,
- doper la région de collecteur et la région MOS avec un premier type de conductivité,
- doper la deuxième région avec un deuxième type de conductivité opposé au type de conductivité de la région de collecteur,
- déposer une couche d'oxyde conforme (122) sur la région bipolaire et sur la région MOS, et
- graver de façon anisotrope la couche conforme de la région bipolaire et de la région MOS.
